# EUROPEAN PATENT APPLICATION

(11) **EP 1 422 765 A2**
(43) Date of publication of application: **26.05.2004**
(21) Application number: 03026641.5
(22) Date of filing: 19.11.2003
(51) Int. Cl.: H01L 51/20

(54) **Highly efficient organic electroluminescent device**

(30) Priority: 20.11.2002 KR 2002072441
(71) Applicant: LG ELECTRONICS INC., Seoul 150-010 (KR)
(72) Inventor: Kim, Sang-Dae, Suseong-gu 706-781 Daegu (KR); Han, Yoon-Soo, Chilgok-gun 718-840 Kyongsangbuk-do (KR); Tak, Yoon-Heung, Gumi-shi 730-765 Kyongsangbuk-do (KR)
(74) Representative: Vetter, Ewald Otto

(57) **Abstract**

The present invention relates to a highly efficient organic electroluminescent device, and particularly to an organic electroluminescent device comprising an anode (a first electrode), a cathode (a second electrode), and one or more organic luminescent layers formed between the anode and the cathode, having an emission layer, wherein the emission layer comprises a doping region having host material and doping material, and a non-doping region having only host material as the hole blocking layer, which is in contact with the doping region, and a preparation method thereof. The organic electroluminescent device of the present invention is characterized in high efficiency, low cost, and improved process without forming the hole blocking layer by using a separate organic material.

## Description

### FIELD OF THE INVENTION

The present invention relates to a highly efficient organic electroluminescent device (OELD), and particularly to an organic electroluminescent device comprising an anode (a first electrode), a cathode (a second electrode), and one or more organic luminescent layers formed between the anode and the cathode, having an emission layer, wherein the emission layer comprises a doping region having host material and doping material, and a non-doping region to play a hole-blocking role having only host material, which is in contact with the doping region, and a preparation method thereof.

### BACKGROUND OF THE INVENTION

The field of display device is a very important field in the information and communication industry. Recently, more advanced performance in this field is asked for in accordance with the development of information and communication technology. Display can be divided into luminescent type and non-luminescent type. The luminescent type of display comprises Cathode Ray Tube (CRT), Electroluminescence Display (ELD), Light Emitting Diode (LED), Plasma Display Panel (PDP), etc. The non-luminescent type of display comprises Liquid Crystal Display (LCD), etc.

The above displays of luminescent type and non-luminescent type have such basic performances as operation voltage, consumption power, brightness, contrast, response rate, life time, etc. However, LCD, which has been widely used up to now, has some problems in the above basic performances in regard to response rate, contrast, and sight dependency. Thus, the display to use LED is anticipated to take the place of next-generation display device by solving the above problems of LCD with many advantages: the speed of response is fast, the back light is not needed because it is a self-emitting type, and the brightness is excellent.

However, LED is mainly used with a crystal form of inorganic material, and so is hard to be applied to a large size of electroluminescent device. In addition, the electroluminescent device using inorganic material needs more than 200 V of operation voltage and is very expensive. However, Eastman Kodak announced manufacturing a device made with a material having π-conjugate structure, such as alumina quinine, in 1987, and thereafter, the electroluminescent device study using organic material has been more active.

The electroluminescence device (EL device, below) can be divided into inorganic EL device and organic EL device depending on a material used to form the emission layer (emitter layer).

The organic EL device is a self-emitting type of device to electrically excite fluorescent organic compound, and is superior in brightness, operation voltage, and response rate to the inorganic EL device, and also can emit multi-color.

In addition, the device is a luminescent device to emit in low voltage current, and has superior properties such as enhanced brightness, high speed of response, wide viewing angle, plane luminescence, slim type, and multi-color luminescence.

The organic EL device is expected to be applicable to a full-color plat panel display due to superior properties that cannot be found in other displays.

C. W. Tang et al. reported the first practical device performance of the organic EL device in Applied Physics Letters, vol. 51 (12) pp 913-915 (1987). They developed a laminated structure of a thin film (a hole transport layer) formed by diamine analogues as organic layer and a thin film (an electron transport layer) formed by tris(8-quinolinolate)aluminum (Alq3, below). The laminated structure can lower the injection barrier of electron and hole from both electrodes to the organic layer, and also can enhance the re-combination probability of electron and hole from the inner organic layer.

Later, C. Adachi et al. developed an organic EL device having an organic luminescent layer with three-laminated structure of hole transport layer, emission layer, and electron transport layer [Japanese Journal of Applied Physics, vol. 27 (2), pp L269-L271 (1988)], and two-laminated structure of hole transportable emission layer and electron transport layer [Applied Physics Letter, vol. 55 (15), pp 1489-1491 (1989)], and showed that the optimization of device property is possible by constructing a multi-layer structure suitable for materials and combination thereof.

The organic EL comprises a first electrode (anode), a second electrode (cathode), and organic luminescent media. This organic luminescent media have at least two separate organic luminescent layers, i.e. one layer to inject and transport electron, and the other layer to inject and transport hole into the device. In addition, another multi-layer of thin organic films can be involved. The above layers to inject and transport electron and hole each can be divided into an electron injection layer, an electron transport layer, a hole injection layer, and a hole transport layer. In addition, the organic luminescent media can further include an emission layer besides the above layers.

The simple structure of organic EL device comprises a first electrode / an electron transport layer, and an emission layer / a second electrode. In addition, the structure of organic EL device can be separated to a first electrode / a hole injection layer / a hole transport layer / an emission layer / an electron transport layer / an electron injection layer / a second electrode.

The driving principle of the organic EL device having the above structure is as follows.

If the voltage is applied to the anode and cathode, the hole injected from the anode is transferred to the emission layer via the hole transport layer. Meanwhile, the electron is injected from the cathode to the emission layer via the electron transport layer. The hole and electron are re-combined in the emission layer to form exiton. The exiton is changed from the excitation state to the basic state, and thereby the fluorescent molecule of the emission layer becomes luminescent to form images.

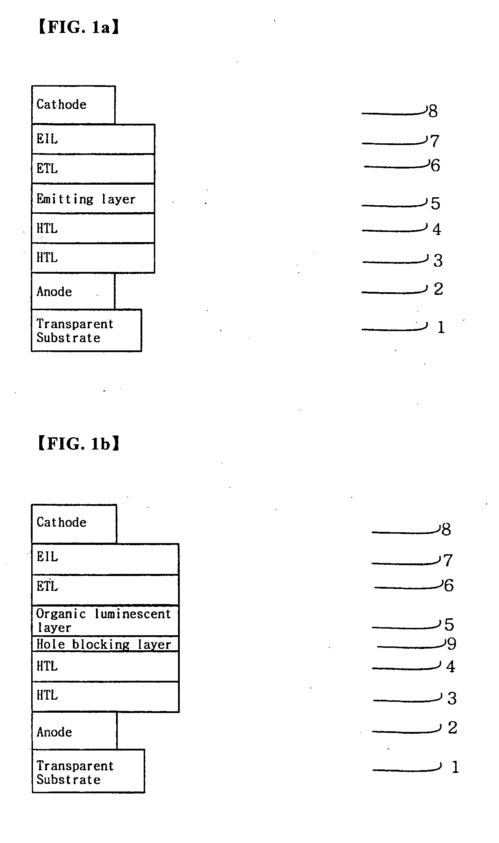

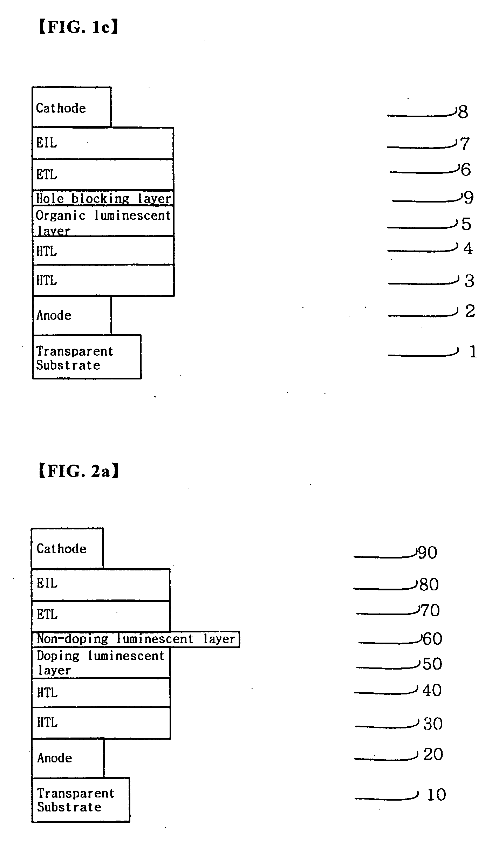

The manufacturing process of a conventional organic EL device is explained with referring to FIG. 1 as follows.

FIG. 1a is a schematic sectional view showing a general organic EL device. As showed in FIG. 1a, an anode material **2** is formed on a glass substrate **1**. At this time, Indium Tin Oxide (ITO) is generally used as the anode material **2**. On the anode material **2** may be formed each the hole injection layer (HIL) **3** or the hole transport layer (HTL) **4**, or both HIL **3** and HTL **4** in order.

At this time, Copper (II) Phthalocyanine is generally used as HIL **3**, and N,N-di(naphthalen -1-yl)-N,N'-diphenylbenzidine as HTL **4**.

Then, an emission layer **5** is formed on HIL **3** or HTL **4**. Particularly, the luminescent material may be used alone as the emission layer **5**, or used by doping a small quantity of impurity to the host material as occasion arises. Thereby can be achieved a high efficiency of luminescence and a modulation of luminescent color. For example, in case of green light, tris(8-hydroxyquinolate) aluminum [Alq3] is used alone as the organic emission layer **5**, or used by doping a material such as N-methylquinacridone to the host like Alq3.

Electron transport layer **6** or electron injection layer **7** is independently or subsequently formed on the emission layer **5**, and a cathode **8** such as aluminum is formed on the electron transport layer **6** or the electron injection layer **7** to form an organic EL device. Generally speaking, Alq3 is used as the electron transport layer, and alkali metal analogue is used as the electron injection layer.

The hole and electron respectively injected by the anode **2** and the cathode **8** are re-combined in the emission layer **5** for luminescence. At this time, the hole blocking layer **9** may be formed between the hole transport layer **4** and the emission layer **5**, or between the emission layer **5** and the electron transport layer **6** to prevent the transferring of hole, and thereby improving the efficiency of luminescence (refer to FIG. 1b and FIG. 1c). The hole blocking layer is a layer formed in contact with the interface of the emission layer in order to make the hole stay on the emission layer longer. Therefore, if the hole stays on the emission layer longer, the number of recombining hole and electron can be increased to enhance the efficiency of luminescence. An example to improve the efficiency of luminescence by forming the hole blocking layer is shown in Japanese Patent Publication 1996-109373, which shows the organic EL device having high efficiency and high driving stability forming triphenyl amine styrene analogue to use as the hole blocking layer.

However, this patent method has many operating problems in the organic EL device manufactured by a deposition process due to applying a material of new structure as the blocking layer. In addition, this method has a problem that the unit manufacturing cost is increased by using the expensive new organic material.

In view of the above, the present inventors have conducted intensive studies in the attempt to construct a highly efficient organic EL device, and found that if the non-doping region of the emission layer itself can play a hole blocking role by forming the emission layer comprising doping region and non-doping region, without forming an additional hole blocking layer with new material and process, the organic EL device of the present invention can be manufactured with little change in the structure of the conventional organic EL device, with simultaneously resolving the problems of the conventional organic EL device, and so the unit manufacturing cost is greatly reduced to enhance the efficiency of luminescence. Therefore, the present inventors completed the present invention.

### SUMMARY OF THE INVENTION

An object of the present invention is to provide an organic EL device which can enhance the efficiency of luminescence and has such advantage as practical convenience in the manufacturing process, comprising a first electrode, one or more organic luminescent layers having an emission layer, and a second electrode, wherein the emission layer comprises a doping region having host material and doping material, and a non-doping region having only host material, in contact with the doping region.

Another object of the present invention is to provide a preparation method of the organic EL device comprising the steps of: forming an anode, a hole injection layer, and a hole transport layer on a substrate in order; forming a doping region of the emission layer; forming a non-doping region of the emission layer; and forming an electron injection layer, an electron transport layer, and a cathode in order.

Preferably, the preparation method of the present invention comprises the steps of: forming an anode and one or more hole-related layers on a substrate in order; forming separately the doping region and non-doping region as the emission layer; and then forming one or more electron-related layers and a cathode in order.

### BRIEF DESCRIPTION OF THE DRAWINGS

The present invention will be more clearly understood from the detailed description in conjunction with the following drawings.
FIG. 1 is a schematic sectional view of a conventional organic EL device.
FIG. 1b and 1c are schematic sectional views of a conventional organic EL device showing the position of a conventional hole blocking layer.
FIG. 2a is a schematic sectional view of an organic EL device of the present invention having enhanced luminescence efficiency.
FIG. 2b is an energy diagram graph of each constructed layer in the organic EL device of the present invention.
FIG. 3 is a graph showing the current intensity - voltage property of Comparative Examples 1 and 2, and Example 1 of the present invention.
FIG. 4 is a graph showing the current intensity - brightness property of Comparative Examples 1 and 2, and Example 1 of the present invention.
FIG. 5 is a graph showing the luminescence efficiency - brightness property of Comparative Examples 1 and 2, and Example 1 of the present invention.

### DETAILED DESCRIPTON OF THE INVENTION

One embodiment of the organic EL device of the present invention having enhanced luminescence efficiency is shown in FIG. 2. The representative example of the present organic EL device will be explained below in reference to FIG. 2. Additional advantages, objects, and features of the present invention will be set forth in the description which follows and will also become apparent to those who practice the present invention. The objectives and other advantages of the present invention will be explained in the written description including the claims as well as the appended drawing. The same reference numerals are used throughout the drawing to indicate same or similar elements.

First of all, an anode **20**, a hole injection layer **30**, and a hole transport layer **40** are subsequently formed on a substrate **10**, and a doping type of emission layer **50** with certain thickness is formed thereon, and then only a host material is further deposited to form a non-doping type of emission layer **60** with certain thickness to prevent the evaporation of dopant. Then, an electron transport layer **70**, an electron injection layer **80**, and a cathode **90** are formed successively thereon to produce the organic EL device of the present invention.

The organic EL device of the present invention may not include an electron, a hole-related injection layer, and/or a transport layer depending on the property of material. The emission layer plays a role to emit light, but mostly also plays a role to transport electron or hole.

In the constituents of the present invention, the ionization potential energy of the doping region of the emission layer **50** becomes less than the inherent potential energy of the host material by impurity (dopant), and so electron affinity can be increased. However, since the non-doping region of the emission layer **60** dose not have impurity (dopant), any change of ionization potential energy and electron affinity is not caused. Therefore, the hole to pass the doping region of the emission layer **50** does not transport rapidly into the electron transport layer **70** at the interface of the non-doping region of the emission layer **60**, and the hole transport is prevented to make the hole stay longer in the emission layer **50**, **60**.

At this time, the electron injected into the emission layer **60** from the cathode via the electron transport layer **70** is recombined with the hole to greatly enhance luminescence efficiency. The energy diagram of each layer is shown in FIG. 2b to help understanding to the above explanation.

In order for the material in the non-doping region of the emission layer **60** to play a role as hole blocking layer, it is preferable that the ionization potential energy thereof is higher than that of the organic luminescent layer adjacent to the emission layer **60**, particularly the electron transport layer **70** (see FIG. 2b). In addition, if the film thickness of the non-doping region of the emission layer is unnecessarily large, the doping property reaches a certain critical point to cause non-doping of the emission layer, and so the doping effect disappears thereby with no enhancement of the property of luminescence. Therefore, the thickness of the non-doping region of the emission layer is preferable to be equal to, or less than, that of the doping region of the emission layer. The thickness of the non-doping region depends on the material to be used, but preferably 1∼15nm. In addition, the thickness of the doping region also depends on the material to be used, but preferably 1∼60nm.

### Comparative Example 1

Copper (II) Phthalocyanine and N,N-di(naphthalen-1-yl)-N,N'- Diphenylbenzidine were each spread on an ITO deposited glass substrate to form a hole injection layer and a hole transport layer by a thickness of 25nm in vacuum of 5 x 10⁻⁶ torr. Then, DPVBi (4,4'-bis(2,2-diphenylvinyl)biphenyl) as host and 2,5,8,11-tetra-tertbutylperylene, perylene analogue, as dopant were co-deposited on the hole transport layer to form 30nm of emission layer. Then, Alq3 was deposited thereon by a thickness of 40nm to form an electron transport layer, and aluminum was deposited thereon by a thickness of 150nm to form a cathode, and thereby an organic EL device was completed.

### Example 1

Copper (II) Phthalocyanine and N,N-di(naphthalen-1-yl)-N,N'- Diphenylbenzidine were each spread on an ITO deposited glass substrate to form a hole injection layer and a hole transport layer by a thickness of 25nm in vacuum of 5 x 10⁻⁶ torr. After that, DPVBi(4,4'-bis(2,2-diphenylvinyl)biphenyl) as host and 2,5,8,11-tetra-tertbutylperylene, perylene analogue, as dopant were co-deposited on the hole transport layer to form the doping region of the emission layer by a thickness of 15nm first, then a shutter of deposition source of dopant was closed, and only the host material was further deposited on the doping layer to form the non-doping region of the emission layer by a thickness of 15nm. Then, Alq3 was deposited thereon by a thickness of 40nm to form an electron transport layer, and aluminum was deposited thereon by a thickness of 150nm to form a cathode, and thereby an organic EL device was completed.

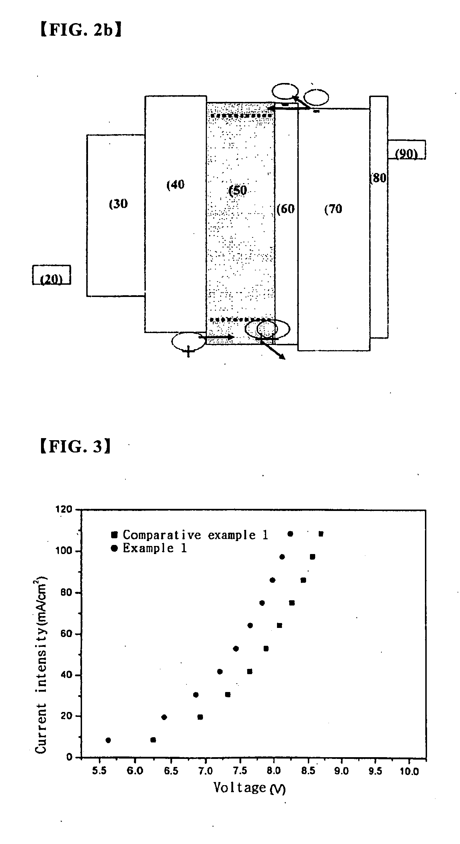

The luminescence property of the organic EL device according to Example 1 and Comparative Example 1 was measured and the results were shown in Table 1 and FIG. 3 to FIG. 5. As shown in FIG. 3, the comparison of current intensity-voltage property of the organic EL device according to the Example 1 and Comparative Example 1 showed that the initial voltage of the organic EL device according to Example 1, into which a thin film of non-doping emission layer to play a role as a hole blocking layer was introduced, was lower than that of the organic EL device according to Comparative Example 1 which has no hole blocking layer.

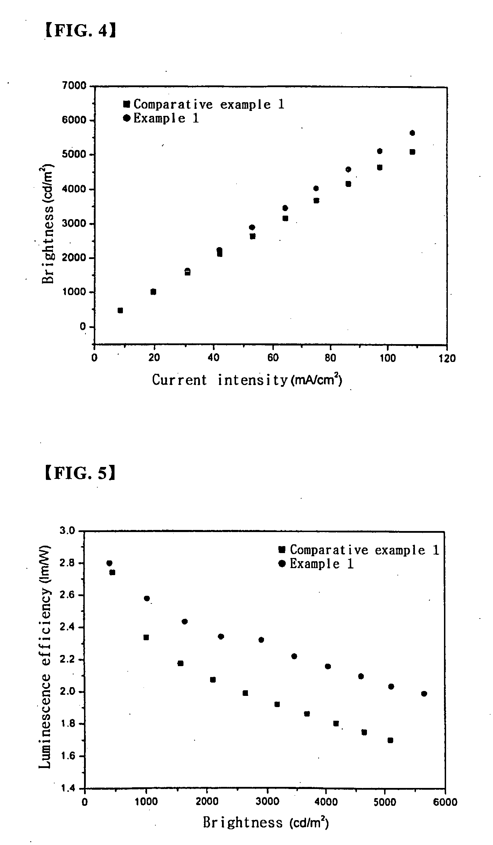

In addition, when comparing the current intensity-brightness property (see FIG. 4) of the examples, the current intensity of the organic EL device according to Exmple 1 was lower than that of the organic EL device according to Comparative Example 1 without the hole blocking layer under the same brightness. This result means a thin film type of non-doping emission layer with certain thickness plays a role as the hole blocking layer to enhance the luminescence efficiency of the organic EL device. In practice, the efficiency of the organic EL device can be greatly increased under same brightness for the hole blocking function of the non-doping region. (see FIG. 5)

In addition, comparing the chromaticity coordinate property of the examples, the color purity of the organic EL device in Example 1 was more enhanced than that of the organic EL device in Comparative Example 1. This result means that the probability of recombining hole and electron on the emission layer was greatly increased through the non-doping region of the emission layer to play a hole blocking function and thereby to prevent injection of the hole from the electron transport layer. The above results are summarized in Table 1.

**[Table 1]**

| | Initial current (V) | Current intensity (mA/cm²) over 3000 cd/m² | Efficiency (lm/W) | Chromaticity coordinate (x,y) |
|---|---|---|---|---|
| Comparative Example 1 | 6. 2 | 60 | 1. 94 | 0. 18, 0.25 |
| Example 1 | 5. 6 | 54 | 2. 3 | 0. 17, 0.22 |

As shown in the above results, the organic EL device according to the present invention can form the hole blocking function layer formed with only the emission layer material without new additional material, and in the deposition process, host and dopant can be co-deposited to form the emission layer without any additional deposition process for hole blocking, and then by depositing only the host material, the organic layer to play the hole blocking function can be formed. Thereby, the manufacturing process can be simplified.

In addition to the mechanical effect of the present invention, the number of processes to manufacture the organic EL device can be reduced in the industry to achieve cost reduction effects by increasing the yield of the manufacturing process and reducing the cost of organic material.

In fact, in the deposition process of organic luminescent layer, a substrate and an organic material source are placed each other face to face, the organic material source is heated to evaporate organic material therein, and this vapor is deposited on the substrate to form an organic luminescent layer. However, in order to further deposit a different kind of organic luminescent layer, the substrate should be transferred to a vessel filled with desired organic material source to go through aligning, heating, and evaporating processes. Therefore, when the kinds of organic material to be evaporated are increased, the tact time, risk of error generation, and difficulty of equipment construction, etc. are increased, too. Those problems are also caused by using the evaporation equipment to move the organic material source without moving the substrate. Further, in case the organic material source is changed to the same vessel, the contamination problem should be considered, and so the probability to cause operation problems is increased. Accordingly, if the same effect can be achieved by decreasing one organic material to be evaporated, it is a very good advantage in view of the yield of the manufacturing process. Surely, the effect of cost reduction is achieved by reducing the number of organic material to be evaporated.

It will be apparent to those skilled in the art that various modifications and variations can be made for the present invention. Therefore, it is intended that the present invention covers the modifications and variations of this invention provided that they come within the scope of the appended claims and their equivalents.

The features of the description, the claims and the drawings, single or in any combination, are patentable, as far as not excluded by the prior art. Each claim can depend on any one or more of the other claims.

## Claims

1. An organic electroluminescent device comprising a first electrode, one or more organic luminescent layers having an emission layer, and a second electrode, wherein the emission layer comprises a doping region having host material and doping material, and a non-doping region having only host material, in contact with the doping region.

2. The organic electroluminescent device according to claim 1, wherein the thickness of said doping region of the emission layer is the same as, or higher than, that of said non-doping region of the emission layer.

3. The organic electroluminescent device according to claim 2, wherein said non-doping region has a thickness of 1∼15nm.

4. The organic electroluminescent device according to claim 2, wherein said doping region has a thickness of 1∼60nm.

5. The organic electroluminescent device according to claim 1, said doping region of the emission layer is in contact with any one of a first electrode, a hole injection layer of the organic luminescent layer, and a hole transport layer of the organic luminescent layer, and said non-doping region of the emission layer is in contact with any one of a second electrode, an electron injection layer of the organic luminescent layer, and an electron transport layer of the organic luminescent layer.

6. A preparation method of the organic electroluminescent device comprising the steps of:
forming an anode, a hole injection layer, and a hole transport layer on a substrate in order;
forming a doping region of the emission layer;
forming a non-doping region of the emission layer; and
forming an electron injection layer, an electron transport layer, and a cathode in order.

7. A preparation method of the organic electroluminescent device comprising the steps of:
forming an anode and one or more hole-related layers on a substrate in order;
forming separately the doping region and non-doping region as the emission layer; and
forming one or more electron-related layers and a cathode in order.
